(19) Europäisches Patentamt
European Patent Office
Office européen des brevets

(11) **EP 2 568 563 A1**

(12) **EUROPEAN PATENT APPLICATION**
published in accordance with Art. 153(4) EPC

(43) Date of publication:
**13.03.2013 Bulletin 2013/11**

(51) Int Cl.:
*H02J 7/00* (2006.01)   *H01M 10/50* (2006.01)
*B60L 11/18* (2006.01)

(21) Application number: **10857021.9**

(22) Date of filing: **06.09.2010**

(86) International application number:
**PCT/KR2010/006029**

(87) International publication number:
**WO 2012/033234 (15.03.2012 Gazette 2012/11)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(71) Applicant: **Volvo Construction Equipment AB 631 85 Eskilstuna (SE)**

(72) Inventors:
• **LEE, Chun-Han**
  **Gimhae-si**
  **Gyeongsangnam-do 621-785 (KR)**

• **CHOI, Dong-Uk**
  **Changwon-si**
  **Gyeongsangnam-do 642-370 (KR)**

(74) Representative: **Zimmermann, Tankred Klaus et al Schoppe, Zimmermann, Stöckeler & Zinkler Patentanwälte**
**Postfach 246**
**82043 Pullach bei München (DE)**

(54) **ENERGY REPOSITORY DISCHARGE SYSTEM FOR CONSTRUCTION MACHINERY**

(57)   A discharge system of a stored energy for a construction machine is provided, which includes the energy storage, an electric discharge device discharging energy stored in the energy storage, and an energy cooling portion increasing the heat dissipation capacity of the electric discharge device by cooling heat generated in the electric discharged device for a time when the energy stored in the energy storage is discharged to the electric discharge device. Since the heat generated in the electric discharge device is cooled by a cooling device while the energy stored in the energy storage is discharged to the electric discharge device, the heat dissipation capacity of the electric discharge device is increased to shorten the discharge time. Also, the operation period of the cooling device is controlled in proportion to the residual voltage of the energy storage, and thus the cooling efficiency is maximized.

【Fig. 2】

EP 2 568 563 A1

## Description

## TECHNICAL FIELD

The present invention relates to a discharge system for a hybrid construction vehicle or a construction machine (for example, excavator), and particularly to, such a discharge system of an energy storage for a hybrid construction vehicle or a construction machine in which heat generated from an electric discharge device is cooled through an energy-cooling unit during the time when the energy stored in the energy storage is discharged by the electric discharge device, thereby increasing the heat dissipation capacity of the electric discharge device to reduce the discharge time of the electric discharge device, and in which much more energy can be discharged for the same period of time than in a conventional discharge system and the operation period of the energy-cooling unit is controlled in proportion to a residual voltage of the energy storage, thereby maximizing the cooling efficiency of the energy-cooling unit.

## BACKGROUND ART

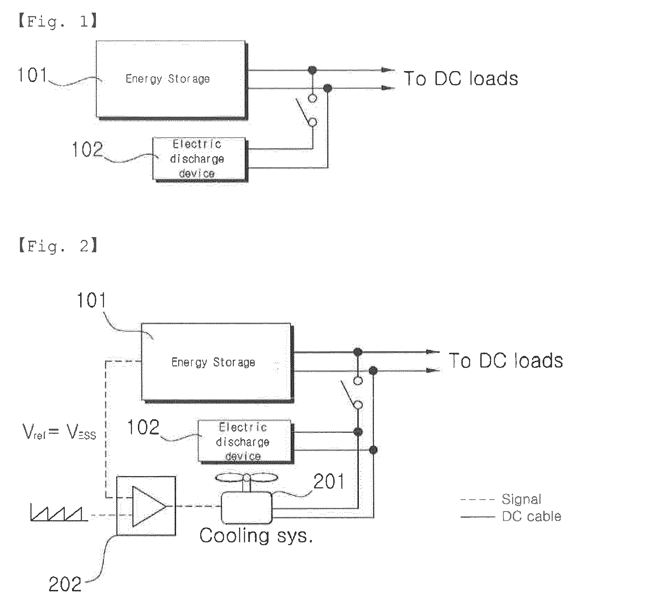

A conventional discharge system requires that the voltage of an energy storage should be discharged to a safe level for the purpose of safety and maintenance. However, the conventional discharge system employing only a resistor device as shown in FIG. 1 entails a problem in that the energy of an energy storage is consumed in an electric discharge device, and thus a large-capacity electric discharge device should be used to discharge the voltage of the energy storage to a desired level for a short time period, leading to a deterioration in the discharge efficiency.

## DISCLOSURE OF INVENTION

## TECHNICAL PROBLEM

Accordingly, the present invention has been made to solve the above-mentioned problem occurring in the prior art, and it is an object of the present invention to provide a discharge system of an energy storage for a construction machine, in which heat generated from an electric discharge device is cooled through an energy-cooling unit during the discharge time in a system employing at least one energy storage, so that the voltage of the energy storage can be discharged to a safe level within a shorter time period, and in which the operation period of the energy-cooling unit is controlled in proportion to a residual voltage of the energy storage, thereby maximizing the cooling efficiency of the energy-cooling unit.

## TECHNICAL SOLUTION

To achieve the above objects, the present invention provides a discharge system of a stored energy for a construction machine, including: an energy storage; an electric discharge device for discharging energy stored in the energy storage; and an energy-cooling unit for cooling heat generated from the electric discharge device during the time when the energy stored in the energy storage is discharged by the electric discharge device, thereby increasing the heat dissipation capacity of the electric discharge device.

Preferably, the discharge system of a stored energy for a construction machine may further includes an operation period control unit for controlling the operation period of the energy-cooling unit in proportion to a residual voltage of the energy storage, thereby increasing the discharge efficiency of the electric discharge device and the operation efficiency of the energy-cooling unit.

Also, preferably, the operation period control unit may perform a control operation such that if the residual voltage of the energy storage is a high voltage, the operation period of the energy-cooling unit is set to a long period so that the operation of the energy-cooling unit is maintained for the long period, while if the residual voltage of the energy storage is a low voltage, the operation period of the energy-cooling unit is set to a short period so that the operation of the energy-cooling unit is maintained for the short period.

## ADVANTAGEOUS EFFECTS

The discharge system of a stored energy for a construction machine according to the present invention as constructed above has the following advantages.

First, heat generated from an electric discharge device is cooled through an energy-cooling unit connected in parallel with the electric discharge device during the time when the energy stored in the energy storage is discharged by the electric discharge device, thereby increasing the heat dissipation capacity of the electric discharge device to reduce the discharge time of the electric discharge device. In addition, much more energy can be discharged for the same period of time than in a conventional discharge system.

Second, the operation period of the energy-cooling unit can be controlled in proportion to a residual voltage of the energy storage, thereby increasing the discharge efficiency of the electric discharge device and the operation efficiency of the energy-cooling unit to increase the operation durability of the electric discharge device and the energy-cooling unit. Moreover, much more energy can be discharged for the same period of time than in a conventional discharge system employing a resistor device, so that when energy of the same capacity is discharged, the resistance value of the resistor device can be set to be lower than that in the conventional discharge system.

Third, the power of the energy storage but not an external power supply is used unlike in the prior art, so that a discharge system can be configured simply.

## BRIEF DESCRIPTION OF THE DRAWINGS

The above and other objects, features and advantages of the present invention will be more apparent from the following detailed description taken in conjunction with the accompanying drawings, in which:

FIG. 1 is a block diagram illustrating the configuration of a conventional discharge system employing only a resistor device according to the prior art;

FIG. 2 is a block diagram illustrating the configuration of a discharge system of a stored energy for a construction machine according to the present invention;

FIG. 3 is a flowchart illustrating the operation of a discharge system of an energy storage for a construction machine according to the present invention; and

FIG. 4 is a graph illustrating the discharge characteristics of an energy storage according to the present invention.

<Explanation on Reference Numerals of Main Elements in the Drawings>

101: energy storage

102: electric discharge device

201: energy-cooling unit

202: operation period control unit

## BEST MODE FOR CARRYING OUT THE INVENTION

Now, preferred embodiments of a control system for a hybrid excavator according to the present invention will be described hereinafter in detail with reference to the accompanying drawings.

FIG. 2 is a block diagram illustrating the configuration of an electric discharge system of an energy storage for a hybrid means of transportation or construction machine (for example, excavator) according to the present invention.

Referring to FIG. 2, the discharge system according to the present invention includes an energy storage (for example, battery or super capacitor), an electric discharge device (for example, a device such as a resistor having a function capable of consuming electric energy) for discharging energy stored in the energy storage, and an energy-cooling unit connected in parallel with the energy storage for cooling heat generated from the electric discharge device during the time when the energy stored in the energy storage is discharged by the electric discharge device, and an operation period control unit for controlling the operation period of the energy-cooling unit in proportion to a residual voltage of the energy storage.

Herein, the energy-cooling unit (for example, a cooling device using cooling water, refrigerant, air, etc.) is connected in parallel with the energy storage and functions to cool heat generated from the electric discharge device during the time when the energy stored in the energy storage is discharged by the electric discharge device, so that the heat dissipation capacity of the electric discharge device can be increased to reduce the discharge time of the electric discharge device, which is expressed by the following Equation 1:

$$[Equation\ 1]$$
$$E_1 = E_2$$
$$E_1 = E_2{}' - E_3$$
$$-> E_2 < E_2{}'$$

wherein $E_1$ is the energy of energy storage, $E_2$ is the heat dissipation energy of a conventional electric discharge device, $E_2$' is the heat dissipation energy of an inventive electric discharge device, and $E_3$ is the cooling energy of a cooling unit.

The operation period control unit serves to control the operation period of the energy-cooling unit in proportion to a residual voltage of the energy storage. More specifically, the operation period control unit performs a control operation such that if the residual voltage of the energy storage 101 is a high voltage by reading the voltage value of the energy storage 101, the operation period of the energy-cooling unit 201 is set to a long period so that the operation of the energy-cooling unit is maintained for the long period. On the contrary, if the residual voltage of the energy storage is a low voltage, the operation period of the energy-cooling unit 201 is set to a short period so that the operation of the energy-cooling unit is maintained for the short period, thereby increasing the discharge efficiency of the electric discharge device and the operation efficiency of the energy-cooling unit to increase the operation durability of the electric discharge device and the energy-cooling unit.

In addition, much more energy can be discharged for the same period of time than in a conventional discharge system employing a resistor device, so that when energy of the same capacity is discharged, the resistance value of the resistor device can be set to be lower than that in the conventional discharge system.

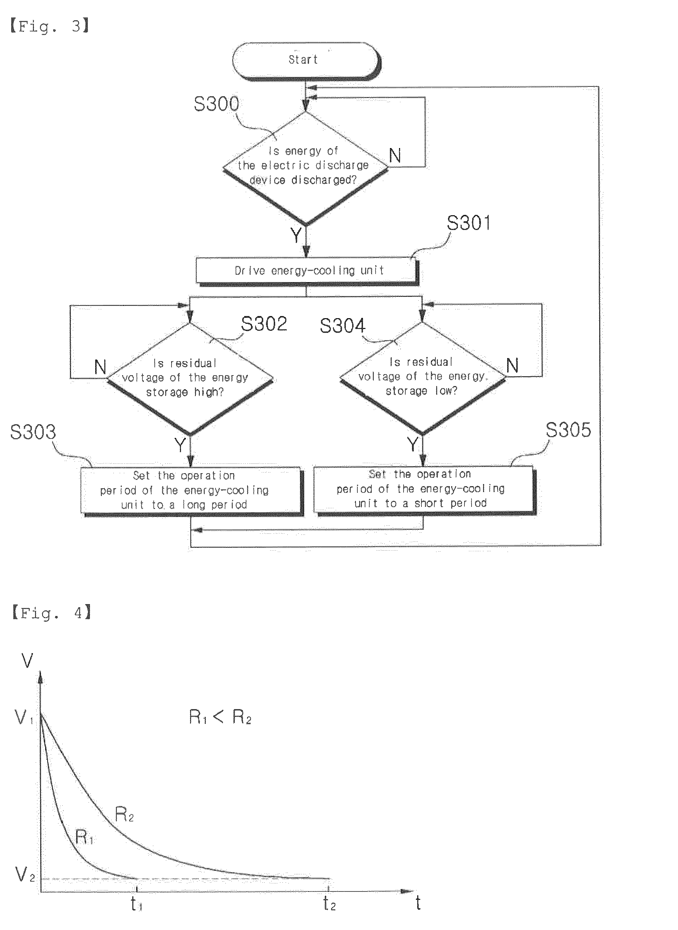

The discharge time of the energy storage is proportional to the resistance value as expressed by the following Equation 2, and thus energy of the same capacity can be discharged for a shorter period of time than in a conventional discharge system as shown in FIG. 4:

$$[Equation\ 2]$$
$$dt = RCln(V_1/V_2)$$

wherein dt is the energy discharge time, R is the resistance value of the resistor device, C is the electrostatic capacity of the energy storage, $V_1$ is the discharge target voltage of the energy storage, and $V_2$ is the initial voltage of the energy storage.

## Mode for Invention

Hereinafter, the flowchart showing the operation of a discharge system of an energy storage for a construction machine (for example, excavator) according to the present invention will be described with reference to FIG. 3.

Referring to FIG. 3, first, the electric discharge device discharges energy stored in the energy storage in response to an input discharge command signal.

Then, the energy-cooling unit cools heat generated from the electric discharge device during the time when the energy stored in the energy storage is discharged by the electric discharge device.

That is, the energy-cooling unit is connected in parallel with the energy storage and cools heat generated from the electric discharge device during the time when the energy stored in the energy storage is discharged by the electric discharge device.

As a result, the heat dissipation capacity of the electric discharge device can be increased to reduce the discharge time of the electric discharge device, which is expressed by the following Equation 3:

$$[\text{Equation } 3]$$

$$E_1 = E_2$$

$$E_1 = E_2' - E_3$$

$$-> E_2 < E_2'$$

wherein $E_1$ is the energy of energy storage, $E_2$ is the heat dissipation energy of a conventional electric discharge device, $E_2'$ is the heat dissipation energy of an inventive electric discharge device, and $E_3$ is the cooling energy of a cooling unit.

Meanwhile, the operation period control unit controls the operation period of the energy-cooling unit 201 in proportion to a residual voltage of the energy storage.

To this end, a voltage value of the energy storage 101 is inputted to the operation period control unit.

Thereafter, if the inputted residual voltage of the energy storage 101 is a high voltage (for example, more than a predetermined value), the operation period control unit controls the operation period of the energy-cooling unit 201 to be set to a long period so that the operation of the energy-cooling unit is maintained for the long period.

On the contrary, if the inputted residual voltage of the energy storage 101 is a low voltage, (for example, less than the predetermined value), the operation period control unit controls the operation period of the energy-cooling unit 201 to be set to a short period so that the operation of the energy-cooling unit 201 is maintained for the short period,

Consequently, the discharge efficiency of the electric discharge device and the operation efficiency of the energy-cooling unit are increased to increase the operation durability of the electric discharge device and the energy-cooling unit.

Further, much more energy can be discharged for the same period of time than in a conventional electric discharge system employing a resistor device, so that when energy of the same capacity is discharged, the resistance value of the resistor device can be set to be lower than that in the conventional discharge system.

The discharge time of the energy storage is proportional to the resistance value as expressed by the following Equation 4, and thus energy of the same capacity can be discharged for a shorter period of time than in a conventional discharge system as shown in FIG. 4:

$$[\text{Equation } 4]$$

$$dt = RCln(V_1/V_2)$$

wherein dt is the energy discharge time, R is the resistance value of the resistor device, C is the electrostatic capacity of the energy storage, $V_1$ is the discharge target voltage of the energy storage, and $V_2$ is the initial voltage of the energy storage.

As described above, heat generated from an electric discharge device is cooled through an energy-cooling unit connected in parallel with the electric discharge device during the time when the energy stored in the energy storage is discharged by the electric discharge device, thereby increasing the heat dissipation capacity of the electric discharge device to reduce the discharge time of the electric discharge device. In addition, much more energy can be discharged for the same period of time than in a conventional discharge system.

Additionally, the operation period of the energy-cooling unit can be controlled in proportion to a residual voltage of the energy storage, thereby increasing the discharge efficiency of the electric discharge device and the operation efficiency of the energy-cooling unit to increase the operation durability of the electric discharge device and the energy-cooling unit. Moreover, much more energy can be discharged for the same period of time than in a conventional discharge system employing a resistor device, so that when energy of the same capacity is discharged, the resistance value of the resistor device can be set to be lower than that in the conventional discharge system.

FIG. 4 is a graph illustrating the discharge characteristics of an energy storage according to the present invention.

As can be seen from the graph in FIG. 4, the discharge characteristics of the energy storage according to the present invention shows that the voltage charged in the energy storage is discharged until it reaches a discharge target voltage while having the energy discharge time characteristics that varies depending on a difference in the resistance value.

In the present invention as described above, much more energy can be discharged for the same period of time than in a conventional discharge system employing a resistor device, so that when energy of the same capacity is discharged, the resistance value of the resistor device can be set to be lower than that in the conventional discharge system.

## INDUSTRIAL APPLICABILITY

The present invention can be utilized in a discharge system of an energy storage for a construction machine. According to the discharge system of the present invention, heat generated from the electric discharge device is cooled through the energy-cooling unit connected in parallel with the electric discharge device during the time when the energy stored in the energy storage is discharged by the electric discharge device, thereby increasing the heat dissipation capacity of the electric discharge device to reduce the discharge time of the electric discharge device. In addition, much more energy can be discharged for the same period of time than in a conventional discharge system.

Furthermore, the present invention can be utilized in a discharge system of an energy storage for a construction machine, in which the operation period of the energy-cooling unit can be controlled in proportion to a residual voltage of the energy storage, thereby increasing the discharge efficiency of the electric discharge device and the operation efficiency of the energy-cooling unit to increase the operation durability of the electric discharge device and the energy-cooling unit.

## Claims

1. A discharge system of a stored energy for a construction machine, comprising:

   an energy storage;
   an electric discharge device for discharging energy stored in the energy storage; and
   an energy-cooling unit for cooling heat generated from the electric discharge device during the time when the energy stored in the energy storage is discharged by the electric discharge device, thereby increasing the heat dissipation capacity of the electric discharge device.

2. The discharge system for a construction machine according to claim 1, further comprising an operation period control unit for controlling the operation period of the energy-cooling unit in proportion to a residual voltage of the energy storage, thereby increasing the discharge efficiency of the electric discharge device and the operation efficiency of the energy-cooling unit.

3. The discharge system for a construction machine according to claim 2, wherein the operation period control unit performs a control operation such that if the residual voltage of the energy storage is a high voltage, the operation period of the energy-cooling unit is set to a long period so that the operation of the energy-cooling unit is maintained for the long period, while if the residual voltage of the energy storage is a low voltage, the operation period of the energy-cooling unit is set to a short period so that the operation of the energy-cooling unit is maintained for the short period.

【Fig. 1】

101  Energy Storage

To DC loads

102  Electric discharge device

【Fig. 2】

101  Energy Storage

To DC loads

$V_{ref} = V_{ESS}$

102  Electric discharge device

201

Cooling sys.

202

- - - - Signal
——— DC cable

【Fig. 3】

```
                        ┌─────────────┐
                        │    Start    │
                        └──────┬──────┘
                               │
        S300                   ▼
              ╱◇╲
            ╱     ╲
          ╱  Is energy of ╲    N
        ◇  the electric discharge ◇───┐
          ╲ device discharged? ╱       │
            ╲     ╱                     │
              ╲◇╱                       │
               │ Y                      │
               ▼          S301          │
        ┌─────────────────────┐        │
        │ Drive energy-cooling unit │  │
        └──────────┬──────────┘        │
          ┌────────┴────────┐           │
          ▼                 ▼           │
   S302              S304               │
    ╱◇╲             ╱◇╲                 │
  N ╱Is residual╲  ╱Is residual╲ N      │
  ◇ voltage of the energy ◇  ◇ voltage of the energy ◇
    ╲storage high?╱  ╲ storage low?╱    │
      ╲◇╱             ╲◇╱               │
       │ Y             │ Y              │
 S303  ▼         S305  ▼                │
┌──────────────┐  ┌──────────────┐      │
│ Set the operation │  │ Set the operation │  │
│ period of the energy-cooling │  │ period of the energy-cooling │
│ unit to a long period │  │ unit to a short period │
└──────┬───────┘  └──────┬───────┘      │
       └─────────┬────────┘             │
                 └──────────────────────┘
```

【Fig. 4】

$R_1 < R_2$

| INTERNATIONAL SEARCH REPORT | International application No. |
|---|---|
| | **PCT/KR2010/006029** |

**A. CLASSIFICATION OF SUBJECT MATTER**

*H02J 7/00(2006.01)i, H01M 10/50(2006.01)i, B60L 11/18(2006.01)i*

According to International Patent Classification (IPC) or to both national classification and IPC

**B. FIELDS SEARCHED**

Minimum documentation searched (classification system followed by classification symbols)
H02J 7/00; B60W 20/00; H01M 10/0525; B60W 10/26; H01M 2/10; H01M 10/50

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: battery, energy reservoir, discharge, cooling, cycle, residual voltage

**C. DOCUMENTS CONSIDERED TO BE RELEVANT**

| Category* | Citation of document, with indication, where appropriate, of the relevant passages | Relevant to claim No. |
|---|---|---|
| X | JP 2007-223570 A (TOYOTA MOTOR CORP) 06 September 2007 | 1 |
| A | See abstract, claims 1 to 4. | 2-3 |
| A | KR 10-2003-0078738 A (ROBERT BOSCH GMBH) 08 October 2003 See abstract, claims 1 to 11. | 1-3 |
| A | KR 10-2010-0041727 A (RIM, JAE HYEON) 22 April 2010 See abstract, claims 1 to 2. | 1-3 |
| A | KR 10-2003-0066765 A (OVONIC BATTERY COMPANY, INC.) 09 August 2003 See abstract, claim 1. | 1-3 |

☐ Further documents are listed in the continuation of Box C.　　☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 MAY 2011 (18.05.2011) | **19 MAY 2011 (19.05.2011)** |

| Name and mailing address of the ISA/KR | Authorized officer |
|---|---|
| Korean Intellectual Property Office Government Complex-Daejeon, 139 Seonsa-ro, Daejeon 302-701, Republic of Korea | |
| Facsimile No. 82-42-472-7140 | Telephone No. |

Form PCT/ISA/210 (second sheet) (July 2009)

INTERNATIONAL SEARCH REPORT
Information on patent family members

International application No.

**PCT/KR2010/006029**

| Patent document cited in search report | Publication date | Patent family member | Publication date |
|---|---|---|---|
| JP 2007-223570 A | 06.09.2007 | JP 4329771 B2 | 09.09.2009 |
| KR 10-2003-0078738 A | 08.10.2003 | CN 1703800 A | 30.11.2005 |
| | | CN 1703800 C0 | 01.08.2007 |
| | | EP 1495511 A2 | 12.01.2005 |
| | | EP 1495511 B1 | 02.11.2006 |
| | | GB 2387019 A | 01.10.2003 |
| | | JP 2003-297438 A | 17.10.2003 |
| | | US 2003-0186114 A1 | 02.10.2003 |
| | | US 2009-0004555 A1 | 01.01.2009 |
| | | WO 03-083961 A2 | 09.10.2003 |
| | | WO 03-083961 A3 | 09.10.2003 |
| KR 10-2010-0041727 A | 22.04.2010 | NONE | |
| KR 10-2003-0066765 A | 09.08.2003 | CA 2276569 A1 | 16.07.1998 |
| | | CA 2276569 C | 14.11.2006 |
| | | JP 2001-507856 A | 12.06.2001 |
| | | JP 4286909 B2 | 03.04.2009 |
| | | KR 10-0422175 B1 | 10.03.2004 |
| | | KR 10-0449983 B1 | 22.09.2004 |
| | | KR 10-2003-0066763 A | 09.08.2003 |
| | | KR 10-2003-0066764 A | 09.08.2003 |
| | | WO 98-31059 A1 | 16.07.1998 |

Form PCT/ISA/210 (patent family annex) (July 2009)